# EUROPEAN PATENT APPLICATION

(11) **EP 4 738 401 A1**
(43) Date of publication of application: **06.05.2026**
(21) Application number: 25211990.4
(22) Date of filing: 29.10.2025
(51) Int. Cl.: H01G 4/008, H01G 4/10, H01G 4/12, H01G 4/33, H10D 1/68

(54) **CAPACITOR, SEMICONDUCTOR DEVICE INCLUDING THE CAPACITOR, METHOD OF FABRICATING THE CAPACITOR**

(30) Priority: 05.11.2024 KR 20240155683
(71) Applicant: Samsung Electronics Co., Ltd., Suwon-si, Gyeonggi-do 16677 (KR)
(72) Inventor: NA, Byunghoon, Suwon-si 16678 (KR); KIM, Sunghyun, Suwon-si 16678 (KR); KIM, Hyowon, Suwon-si 16678 (KR); LEE, Jooho, Suwon-si 16678 (KR)
(74) Representative: Elkington and Fife LLP

(57) **Abstract**

Provided are a capacitor, a semiconductor device including the capacitor, and a method of fabricating the capacitor. The capacitor includes a first electrode, a ferroelectric layer on the first electrode, a second electrode on the ferroelectric layer, and an interfacial layer between the first electrode and the ferroelectric layer and/or between the ferroelectric layer and the second electrode.

## Description

### FIELD OF THE INVENTION

This disclosure relates to capacitors, semiconductor devices including the capacitors, and/or methods of fabricating the capacitors.

### BACKGROUND OF THE INVENTION

With the downscaling of integrated circuit devices, the space occupied by capacitors has also decreased. Capacitors consist of a first electrode, a second electrode, and a dielectric layer provided between the first and second electrodes, and the dielectric layer includes a high-k material to enhance capacitance. However, as the size of capacitors decreases, leakage current may flow within the capacitors. Thus, techniques for reducing leakage current flowing within capacitors while suppressing a decrease in the capacitance of the capacitors are needed.

### SUMMARY OF THE INVENTION

Some example embodiments provide capacitors including an interfacial layer that enhances the crystallization of a ferroelectric layer.

Some example embodiments provide semiconductor devices including a capacitor with a ferroelectric layer having enhanced ferroelectricity.

Some example embodiments provide methods of fabricating a capacitor.

Additional aspects will be set forth in part in the description which follows and, in part, will be apparent from the description, or may be learned by practice of the presented example embodiments of the disclosure.

According to an example embodiment of the disclosure, a capacitor includes a first electrode, a ferroelectric layer on the first electrode, a second electrode on the ferroelectric layer, and an interfacial layer between the first electrode and the ferroelectric layer and/or between the ferroelectric layer and the second electrode, wherein the interfacial layer includes a perovskite structure material, the perovskite structure material includes an oxide of metals, the metals include a divalent cation, a tetravalent cation, and a trivalent cation, and the trivalent cation includes at least one selected from Sc, Y, La, Ce, Pr, Nd, Sm, Dy, Al, Ga, or In.

The divalent cation of the interfacial layer may include at least one selected from La, Sr, Ba, Nd, Pb, Ca, Na, Eu, or Rb.

The tetravalent cation of the interfacial layer may include at least one selected from Ti, Ta, Zr, Hf, or Sn.

The first electrode and the second electrode may include at least one selected from a perovskite structure material or a rock-salt structure material.

The first electrode and the second electrode may include at least one selected from SrRuO₃, SrIrO₃, SrFeO₃, SrCoO₃, SrMnO₃, CaRuO₃, LaMnO₃, La₍ₓ₎Sr₍₁₋ₓ₎MnO₃, LaNiO₃, LaFeO₃, LaCoO₃, BN, AIN, GaN, Si₃N₄, Ta₃N₅, Cu₃N, InN, Zr₃N₄, Hf₃N₄, LaN, LuN, TiN, MN, VN, TaN, WN, HfN, NbN, or ZrN.

The ferroelectric layer may include at least one selected from a perovskite structure, a fluorite structure, or a wurtzite structure.

The ferroelectric layer may include at least one selected from BaTiO₃, Ba₍ₓ₎Sr₍₁₋ₓ₎TiO₃, PbTiO₃, PbZrO₃, PbTi₍ₓ₎Zr₍₁₋ₓ₎O₃, PbMg₍ₓ₎Nb₍₁₋ₓ₎O₃, PbZn₍ₓ₎Nb₍₁₋ₓ₎O₃, PbFe₍ₓ₎Nb₍₁₋ₓ₎O₃, PbNi₍ₓ₎Nb₍₁₋ₓ₎O₃, PbMg₍ₓ₎Ta₍₁₋ₓ₎O₃, PbMg₍ₓ₎W₍₁₋ₓ₎O₃, BiFeO₃, KNbO₃, NaNbO₃, or Sr₂Bi₂TaO₉.

The ferroelectric layer may include HfO₂ or HfO₂ doped with A, and A may include at least one selected from Sr, Sc, Y, Al, La, Si, Gd, Zr, N, or Ge.

The ferroelectric layer may include hafnium zirconium oxide (HZO).

The ferroelectric layer may include at least one selected from Sc₍ₓ₎Al₍₁₋ₓ₎N, Y₍ₓ₎Al₍₁₋ₓ₎N, Mg₍ₓ₎Zr₍₁₋ₓ₎N, Ga₍ₓ₎Sc₍₁₋ₓ₎N, Sc₍ₓ₎Al_{(1-x-y)}Ga_{(y)}N, or Zn₍ₓ₎Mg₍₁₋ₓ₎O.

The ferroelectric layer may have a superlattice structure.

The interfacial layer may have a negative charge.

According to another example embodiment of the disclosure, a semiconductor device includes a substrate, a gate structure on the substrate, a source region and a drain region being apart from each other in the substrate, and a capacitor over the substrate. The capacitor includes a first electrode, a ferroelectric layer on the first electrode, a second electrode on the ferroelectric layer, and an interfacial layer between the first electrode and the ferroelectric layer and/or between the ferroelectric layer and the second electrode. The interfacial layer includes a perovskite structure material. The interfacial layer includes an oxide of metals, and the metals include a divalent cation, a tetravalent cation, and a trivalent cation. The trivalent cation includes at least one selected from Sc, Y, La, Ce, Pr, Nd, Sm, Dy, Al, Ga, or In.

According to another example embodiment of the disclosure, a method of fabricating a capacitor includes forming a ferroelectric layer on a first electrode, forming a second electrode on the ferroelectric layer, and forming an interfacial layer between the first electrode and the ferroelectric layer and/or between the ferroelectric layer and the second electrode. The interfacial layer has a perovskite structure material. The interfacial layer includes an oxide of metals. The metals include a divalent cation, a tetravalent cation, and a trivalent cation. The trivalent cation includes at least one selected from Sc, Y, La, Ce, Pr, Nd, Sm, Dy, Al, Ga, or In.

### BRIEF DESCRIPTION OF THE DRAWINGS

The above and other aspects, features, and advantages of certain example embodiments of the disclosure will be more apparent from the following description taken in conjunction with the accompanying drawings, in which:
FIG. 1 is a cross-sectional view illustrating a capacitor according to an example embodiment;
FIG. 2 is a cross-sectional view illustrating an example in which the position of an interfacial layer of the capacitor shown in FIG. 1 is changed;
FIG. 3 is a cross-sectional view illustrating a capacitor including two interfacial layers, according to an example embodiment;
FIG. 4 is a cross-sectional view illustrating a capacitor including a ferroelectric layer with a superlattice structure, according to an example embodiment;
FIG. 5 is a graph illustrating the degree of crystallization of a capacitor according to an example embodiment;
FIG. 6 is a view illustrating a crystal structure of a capacitor according to an example embodiment;
FIG. 7 is a transmission electron microscopy (TEM) image illustrating a capacitor according to an example embodiment.
FIG. 8 illustrates a polarization-volage graph of a capacitor according to an example embodiment;
FIG. 9 illustrates a polarization-electric field graph of a capacitor according to a comparative example;
FIG. 10 illustrates a polarization-voltage graph of a capacitor according to another comparative example;
FIGS. 11 and 12 are views illustrating a method of fabricating a capacitor, according to an example embodiment;
FIG. 13 is view illustrating a semiconductor device according to an example embodiment;
FIG. 14 is a view illustrating a semiconductor device according to another example embodiment;
FIG. 15 is a cross-sectional view taken along line A-A' of FIG. 14;
FIG. 16 is a view illustrating a semiconductor device according to another example embodiment;
FIG. 17 is a conceptual view schematically illustrating a device architecture applicable to an electronic device, according to an example embodiment; and
FIG. 18 is a conceptual view schematically illustrating a device architecture applicable to an electronic device, according to an example embodiment.

### DETAILED DESCRIPTION

Reference will now be made in detail to example embodiments, examples of which are illustrated in the accompanying drawings, wherein like reference numerals refer to like elements throughout. In this regard, the present example embodiments may have different forms and should not be construed as being limited to the descriptions set forth herein. Accordingly, the example embodiments are merely described below, by referring to the figures, to explain aspects. As used herein, the term "and/or" includes any and all combinations of one or more of the associated listed items. Expressions such as "at least one of," "one of," "on or more of," "any one of," and "at least one selected from" when preceding a list of elements, modify the entire list of elements and do not modify the individual elements of the list. Thus, for example, both "at least one of A, B, or C" and "at least one of A, B, and C" mean either A, B, C or any combination thereof. Likewise, A and/or B means A, B, or A and B.

Hereinafter, capacitors, semiconductor devices including the capacitors, and method of fabricating the capacitors will be described according to various example embodiments with reference to the accompanying drawings. In the drawings, like reference numbers refer to like elements, and the size of each element may be exaggerated for clarity of illustration. It will be understood that although terms such as "first" and "second" may be used herein to describe various components, these components should not be limited by these terms. These terms are only used to distinguish one element from another.

As used herein, singular forms may include plural forms as well unless the context clearly indicates otherwise. It will be further understood that the terms "comprises," "comprising," "includes," and/or "including" used herein specify the presence of stated features or elements, but do not preclude the presence or addition of one or more other features or elements. In the drawings, the size or thickness of each element may be exaggerated for clarity of illustration. Furthermore, it will be understood that when a material layer is referred to as being "on" or "above" a substrate or another layer, it can be directly on the substrate or the other layer, or intervening layers may also be present. Furthermore, in the following example embodiments, a material included in each layer is an example, and another material may be used in addition to or instead of the material.

While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

When the term "about," "substantially" or "approximately" is used in this specification in connection with a numerical value, it is intended that the associated numerical value includes a manufacturing or operational tolerance (e.g., ±10%) around the stated numerical value. Moreover, when the word "about," "substantially" or "approximately" is used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.

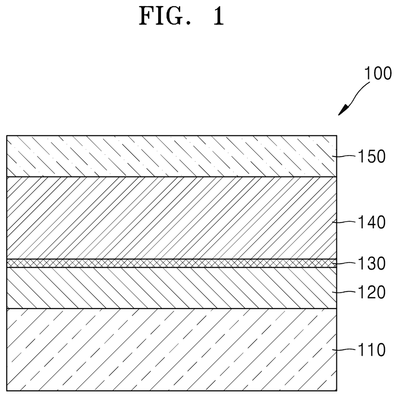

FIG. 1 is a cross-sectional view illustrating a capacitor 100 according to an example embodiment.

Referring to FIG. 1, the capacitor 100 includes a substrate 110, a first electrode 120 provided on the substrate 110, a ferroelectric layer 140 provided above the first electrode 120, and a second electrode 150 provided on the ferroelectric layer 140.

The capacitor 100 may include an interfacial layer 130 provided in at least one of a region between the first electrode 120 and the ferroelectric layer 140 and a region between the ferroelectric layer 140 and the second electrode 150. In other words, the capacitor 100 may include an interfacial layer 130 that is provided between the first electrode 120 and the ferroelectric layer 140 and/or between the ferroelectric layer 140 and the second electrode 150. FIG. 1 shows an example in which the interfacial layer 130 is provided between the first electrode 120 and the ferroelectric layer 140.

The substrate 110 may be a silicon substrate, a glass substrate, a sapphire substrate, or a silicon substrate coated with SiO₂. However, this is merely an example, and the substrate 110 may include various other materials. The substrate 110 may be removed, or when the capacitor 100 is combined with another device, the substrate 110 may form a layer of the other device.

The first electrode 120 and the second electrode 150 may have conductivity as electrodes and may maintain stable capacitance performance even after high-temperature processes during the manufacturing of the capacitor 100. The first electrode 120 and the second electrode 150 may each include at least one selected from a perovskite structure material or a rock-salt structure material.

When the first electrode 120 and the second electrode 150 each include a perovskite structure material, the first electrode 120 and the second electrode 150 may each include, for example, at least one selected from SrRuO₃, SrTiO₃, SrIrO₃, SrFeO₃, SrCoO₃, SrMnO₃, CaRuO₃, LaMnO₃, La₍ₓ₎Sr₍₁₋ₓ₎MnO₃, LaNiO₃, LaFeO₃, or LaCoO₃. When the first electrode 120 and the second electrode 150 each include a rock-salt structure material, the first electrode 120 and the second electrode 150 may each include, for example, at least one selected from BN, AIN, GaN, Si₃N₄, Ta₃N₅, Cu₃N, InN, Zr₃N₄, Hf₃N₄, LaN, LuN, TiN, MN, VN, TaN, WN, HfN, NbN, or ZrN. The first electrode 120 and the second electrode 150 may include the same material. However, example embodiments are not limited thereto, and the first electrode 120 and the second electrode 150 may include different materials.

The interfacial layer 130 may include a perovskite structure material and may have a negative charge. The interfacial layer 130 may include an oxide of metals, and the metals may include a divalent cation, a tetravalent cation, and a trivalent cation. For example, the interfacial layer 130 may include a material represented by ABB'O₃, where A refers to a divalent cation, B refers a tetravalent cation, and B' refers to a trivalent cation.

For example, the A of the interfacial layer 130 may include at least one selected from La, Sr, Ba, Nd, Pb, Ca, Na, Eu, or Rb. The B of the interfacial layer 130 may include at least one selected from Ti, Ta, Zr, Hf, or Sn. The B' of the interfacial layer 130 may include at least one selected from Sc, Y, La, Ce, Pr, Nd, Sm, Dy, Al, Ga, or In. The interfacial layer 130 may include, for example, SrScTiO₃, SrYTiO₃, LaAlTiO₃, or SrAlTiO₃.

The interfacial layer 130 may promote crystallization of the ferroelectric layer 140. As the ferroelectric layer 140 crystallizes, the ferroelectric lay 140 may exhibit ferroelectricity and reduces leakage current, thereby improving the performance of the capacitor 100.

The ferroelectric layer 140 may include a ferroelectric material that exhibits ferroelectricity by maintaining spontaneous polarization as internal electric dipole moments align even without an externally applied electric field. When no external electric field is applied to the ferroelectric material, the ferroelectric material has random polarization directions. However, when an external electric field is applied to the ferroelectric material, the polarization magnitude of the ferroelectric material increases to align with the direction of the external electric field. The ferroelectric material has the characteristic of maintaining polarization alignment in one direction even after an electric field applied to the ferroelectric material is removed.

The ferroelectric layer 140 may include at least one selected from a perovskite structure, a fluorite structure, or a wurtzite structure.

When the ferroelectric layer 140 has a perovskite structure, the ferroelectric layer 140 may include, for example, at least one selected from BaTiO₃, Ba₍ₓ₎Sr₍₁₋ₓ₎TiO₃, PbTiO₃, PbZrO₃, PbTi₍ₓ₎Zr₍₁₋ₓ₎O₃, PbMg₍ₓ₎Nb₍₁₋ₓ₎O₃, PbZn₍ₓ₎Nb₍₁₋ₓ₎O₃, PbFe₍ₓ₎Nb₍₁₋ₓ₎O₃, PbNi₍ₓ₎Nb₍₁₋ₓ₎O₃, PbMg₍ₓ₎Ta₍₁₋ₓ₎O₃, PbMg₍ₓ₎W₍₁₋ₓ₎O₃, BiFeO₃, KNbO₃, NaNbO₃, or Sr₂Bi₂TaO₉.

When the ferroelectric layer 140 has a fluorite structure, the ferroelectric layer 140 may include hafnium oxide (HfO₂) or hafnium oxide (HfO₂) containing a dopant A. The dopant A may include, for example, at least one selected from Sr, Sc, Y, Al, La, Si, Gd, Zr, N, or Ge. In some example embodiments, the ferroelectric layer 140 may include hafnium and zirconium in almost equal atomic ratios (e.g., Hf_{0.5}Zr_{0.5}O₂) and may be additionally doped with at least one element selected from lanthanum (La), aluminum (Al), silicon (Si), yttrium (Y), or gadolinium (Gd) at a concentration of less than 10 at%.

When the ferroelectric layer 140 has a wurtzite structure, the ferroelectric layer 140 may include zinc oxide (ZnO) or aluminum nitride (AIN). The ferroelectric layer 140 may include, for example, at least one selected from Sc₍ₓ₎Al₍₁₋ₓ₎N, Y₍ₓ₎Al₍₁₋ₓ₎N, Mg₍ₓ₎Zr₍₁₋ₓ₎N, Ga₍ₓ₎Sc₍₁₋ₓ₎N, Sc₍ₓ₎Al_{(1-x-y)}Ga_{(y)}N, or Zn₍ₓ₎Mg₍₁₋ₓ₎O.

When the ferroelectric layer 140 crystallizes, the ferroelectricity of the ferroelectric layer 140 may be enhanced. The interfacial layer 130 may promote or enhance crystallization of the ferroelectric layer 140, and thus, the ferroelectric layer 140 may have an orthorhombic phase or a rhombohedral phase.

In the capacitor 100, the interfacial layer 130, which include a material represented by ABB'O₃ and have a negative charge, may promote crystallization of the ferroelectric layer 140. Generally, in materials with an ABO₃ perovskite structure, the element A is divalent (A²⁺), and the element B is tetravalent (B⁴⁺), resulting in charge neutrality. In the interfacial layer 130 (ABB'O₃), however, the addition of a trivalent element B'³⁺ to an element B site breaks charge neutrality, giving the interfacial layer 130 (ABB'O₃) a negative charge. When the interfacial layer 130 (ABB'O₃) having a negative charge is placed between the first electrode 120 and the ferroelectric layer 140, electrons of the first electrode 120 may migrate to the interfacial layer 130, forming a relatively strong negative charge between the ferroelectric layer 140 and the first electrode 120. In addition, the ferroelectric layer 140 having an orthorhombic or rhombohedral phase may stably maintain strong ferroelectricity when the ferroelectric layer 140 stably maintains internal oxygen vacancies. The negative charge of the interfacial layer 130 may stably control positively charged oxygen vacancies present in the ferroelectric layer 140 disposed above the interfacial layer 130. Therefore, owing to the interfacial layer 130, the ferroelectric layer 140 may be formed as a high-crystallinity orthorhombic or rhombohedral ferroelectric layer.

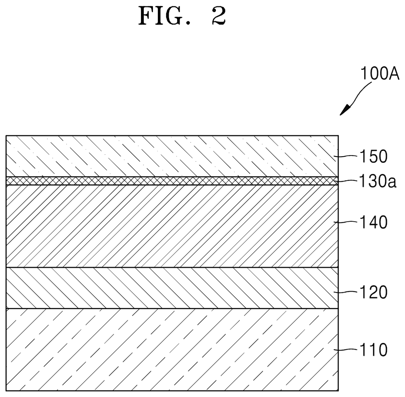

FIG. 2 is a cross-sectional view illustrating a capacitor 100A according to an example embodiment.

Comparing the capacitor 100A with the capacitor 100 shown in FIG. 1, the position of an interfacial layer 130a is different. In FIGS. 2 and 1, like reference numerals denote like elements, and thus, repeated descriptions thereof are omitted here. The interfacial layer 130a may be disposed between a ferroelectric layer 140 and a second electrode 150. The interfacial layer 130a may have substantially the same structure and function as the interfacial layer 130 described with reference to FIG. 1. A negative charge of the interfacial layer 130a may function to stably control positively charged oxygen vacancies present in the ferroelectric layer 140 located below the interfacial layer 130a. Thus, owing to the interfacial layer 130a, the ferroelectric layer 140 may be formed as a relatively high-crystallinity orthorhombic or rhombohedral ferroelectric layer.

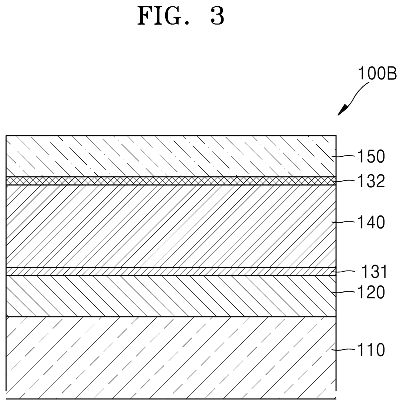

FIG. 3 is a cross-sectional view illustrating a capacitor 100B including two interfacial layers.

The capacitor 100B may include a first interfacial layer 131 disposed between a first electrode 120 and a ferroelectric layer 140 and a second interfacial layer 132 disposed between the ferroelectric layer 140 and a second electrode 150. The first interfacial layer 131 and the second interfacial layer 132 may each include an ABB'O₃ material having a negative charge. The ABB'O₃ material is substantially the same as that described with reference to FIG. 1. The first interfacial layer 131 and the second interfacial layer 132 may include the same material. However, example embodiments are not limited thereto. For example, the first interfacial layer 131 and the second interfacial layer 132 may include different materials.

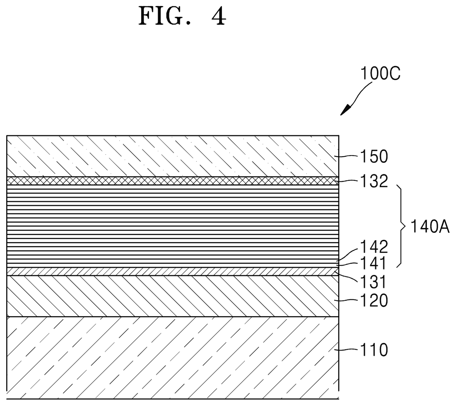

FIG. 4 is a cross-sectional view illustrating a capacitor 100C according to an example embodiment.

The capacitor 100C differs from the capacitor 100B shown in FIG. 3 in the structure of a ferroelectric layer 140A. The ferroelectric layer 140A may have a superlattice structure. The superlattice structure refers to a structure in which two different materials are alternately stacked. The ferroelectric layer 140A may have a structure in which first material layers 141 and second material layers 142, different from the first material layers 141, are alternately stacked. For example, the ferroelectric layer 140A may have a structure in which atomic layers of hafnium oxide and zirconium oxide each having a thickness of 0.5 nanometers are alternately stacked. The superlattice structure of the ferroelectric layer 140A may further enhance the ferroelectricity of the ferroelectric layer 140A.

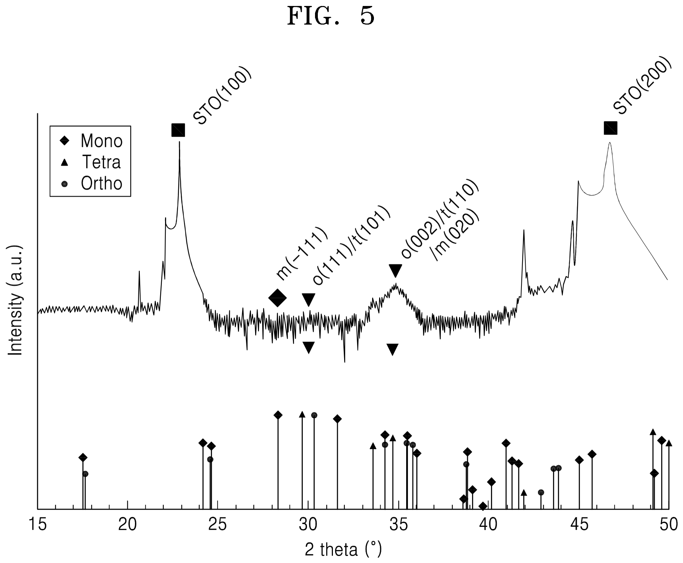

FIG. 5 is a graph illustrating the degree of crystallization of a capacitor according to an example embodiment. The capacitor of the example embodiment has an SRO/SATO(-)/HZO stacked structure. SRO refers to an electrode material (strontium ruthenium oxide), SATO(-) refers to an interfacial layer material (strontium aluminum tantalum oxide) with a negative charge, and HZO refers to a ferroelectric layer material (hafnium zirconium oxide). An HZO ferroelectric layer has a thickness of about 35 nm. FIG. 5 shows light intensity with respect to a crystallization angle 2-theta based on X-ray diffraction (XRD) and reflection high-energy electron diffraction (RHEED) analyses. A peak value at the crystallization angle 2-theta indicates crystallization. The crystallization angle 2-theta may differ for each material. In FIG. 5, a peak value appears at about 35 degrees, indicating that the HZO ferroelectric layer has crystallized into an orthorhombic crystal structure. In the graph, o refers to orthorhombic, t refers to tetragonal, and m refers to monoclinic.

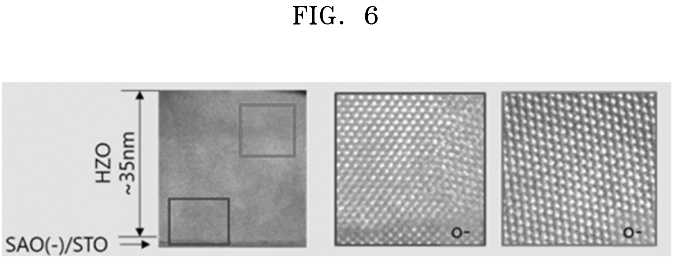

FIG. 6 shows the crystallization structure of a ferroelectric layer. When a lower region and an upper region of the ferroelectric layer are enlarged, both the lower region and the upper region exhibit orthorhombic crystal structures.

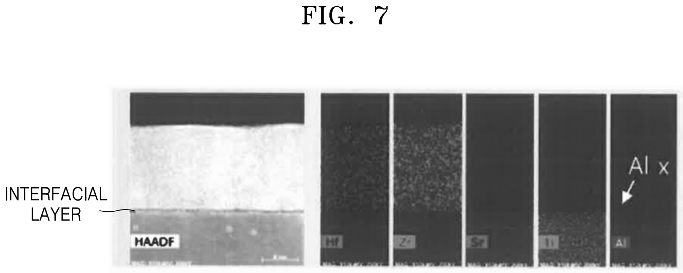

FIG. 7 shows a transmission electron microscopy (TEM) image of an STO/SATO(-)/HZO capacitor. Sr, Ti, and Al elements of a SATO(-) interfacial layer were identified. The SATO(-) interfacial layer may be checked using, for example, high-angle annular dark-field scanning transmission electron microscopy (HAADF-STEM).

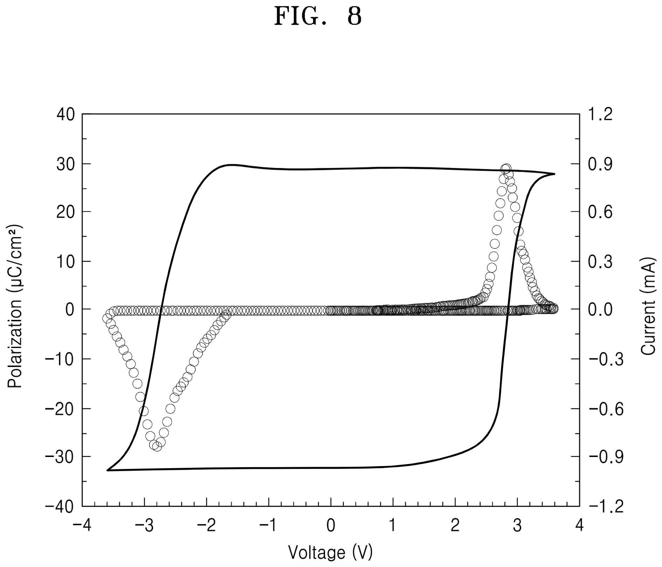

FIG. 8 shows the polarization and current of a capacitor with respect to voltage, according to an example embodiment. In FIG. 8, a solid curve refers to polarization, and a curve drawn with small hollow circles refers to current. The capacitor of the example embodiment has a stacked structure of SRO electrode/SATO(-) interfacial layer/HZO ferroelectric layer, with a distance d of about 8 nm between first and second electrodes, a capacitor area A of about 20 µm × 20 µm, and a remnant polarization Pr of about 40 µC/cm².

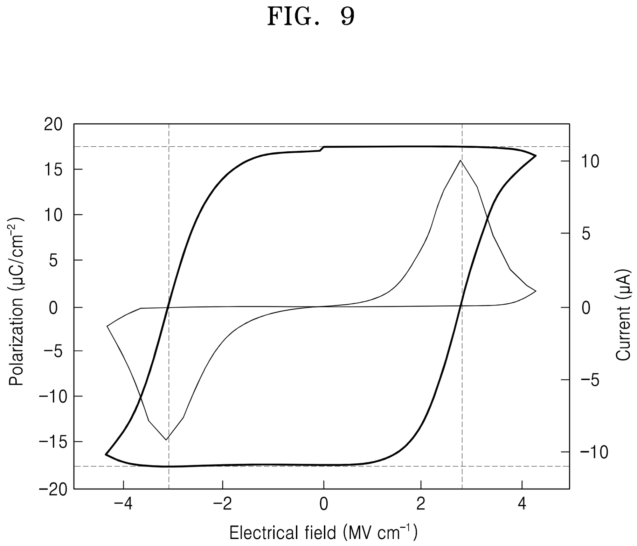

FIG. 9 shows the polarization and current of a capacitor with respect to voltage, according to a comparative example. The capacitor of the comparative example has a stacked structure of LaSrMnO₃ (LSMO) electrode/HZO ferroelectric layer. In FIG. 9, a thick curve refers to polarization, and a thin curve refers to current. In the comparative example, a distance d between first and second electrodes is about 9 nm, the area A of the capacitor is about 50 µm × 50 µm, and remnant polarization Pr is about 18 µC/cm².

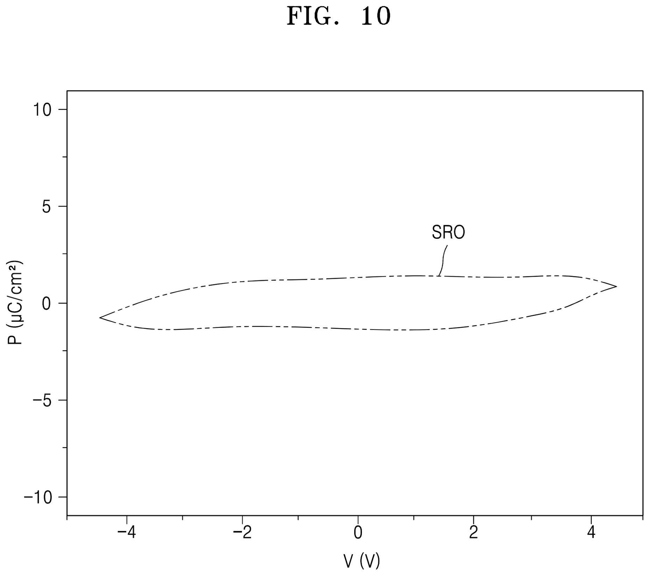

FIG. 10 shows the polarization of a capacitor with respect to voltage, according to another comparative example. The capacitor of the other comparative example has a stacked structure of SRO electrode/HZO ferroelectric layer. The capacitor of the comparative example has a remnant polarization Pr of about 2.5 µC/cm² and a thickness d of about 9.5 nm.

The capacitor of the example embodiment exhibits higher remnant polarization than the capacitors of the two comparative examples. While the capacitors of the comparative examples require or need a separate wake-up process, such as several tens to several hundred of polarization-voltage (P-V) measurements, to increase remnant polarization, the capacitor of the example embodiment may exhibit relatively high remnant polarization without such an electrical wake-up process.

In the capacitors 100, 100A, 100B, and 100C of the above example embodiments, the crystallization of the ferroelectric layers 140 and 140A may be promoted or enhanced by the interfacial layers 130 and 130a and the first and second interfacial layers 131 and 132, thereby improving the ferroelectricity of the ferroelectric layers 140 and 140A and/or ensuring the crystallization of the ferroelectric layers 140 and 140A regardless of the types of electrodes.

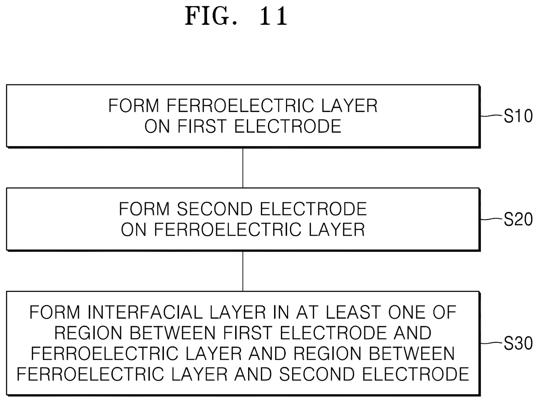

FIG. 11 is a view illustrating a method of fabricating a capacitor according to an example embodiment.

Referring to FIG. 11, according to the example embodiment, the method of fabricating a capacitor includes forming a ferroelectric layer on a first electrode (S10) and forming a second electrode on the ferroelectric layer (S20). In addition, an interfacial layer may be formed in at least one of a region between the first electrode and the ferroelectric layer and a region between the ferroelectric layer and the second electrode (S30). In other words, an interfacial layer may be formed between the first electrode and the ferroelectric layer and/or between the ferroelectric layer and the second electrode (S30). Operations S10, S20, and S30 of the capacitor fabricating method are not limited to proceeding in chronological order. When the interfacial layer is formed between the first electrode and the ferroelectric layer, the first electrode may first be formed, the interfacial layer may be formed on the first electrode, and then the ferroelectric layer may be formed on the interfacial layer. When the interfacial layer is formed between the ferroelectric layer and the second electrode, the first electrode may first be formed, the ferroelectric layer may be formed on the first electrode, and then, the interfacial layer may be formed on the ferroelectric layer. The interfacial layer may be formed by a physical vapor deposition method, a chemical vapor deposition method, or an atomic layer deposition method.

The interfacial layer may include a perovskite structure material and may have a negative charge. The interfacial layer may include a material represented by ABB'O₃, where A refers to a divalent cation, B refers to a tetravalent cation, and B' refers to a trivalent cation, and B' may include at least one selected from Sc, Y, La, Ce, Pr, Nd, Sm, Dy, Al, Ga, or In.

Before the ferroelectric layer is heat treated, the ferroelectric layer may be an amorphous layer in which a ferroelectric material is not crystallized. The ferroelectric layer may be formed by a physical vapor deposition method, a chemical vapor deposition method, or an atomic layer deposition method. For example, when the ferroelectric layer is formed of or includes Hf_{0.5}Zr_{0.5}O₂, hafnium oxide and zirconium oxide may be alternately deposited by an atomic layer deposition method to form an amorphous Hf_{0.5}Zr_{0.5}O₂ layer.

Then, the amorphous ferroelectric material layer (e.g., the amorphous Hf_{0.5}Zr_{0.5}O₂ layer) may be crystallized through heat treatment to form the ferroelectric layer. For example, a layer including a first material may be formed on an amorphous layer, and the amorphous layer may be crystallized through heat treatment to form the ferroelectric layer. The first material may include, for example, at least one selected from Mo, TiN, W, or ITO.

The heat treatment may be performed under conditions that allow an amorphous hafnium-based oxide to crystallize into an orthorhombic crystal phase. For example, annealing may be performed at a temperature of about 400 °C to about 1100 °C, but example embodiments are not limited thereto. The time period of the annealing may be 1 nanosecond or more, 1 microsecond or more, 0.001 second or more, 0.01 second or more, 0.05 second or more, 0.1 second or more, 0.5 second or more, 1 second or more, 3 seconds or more, or 5 seconds or more, but may not exceed 10 minutes, 5 minutes, 1 minute, or 30 seconds. However, example embodiments are not limited thereto. After forming the ferroelectric layer, the first material may be removed.

According to the capacitor fabricating method the example embodiment, the ferroelectric layer may be effectively crystallized owing to the interfacial layer.

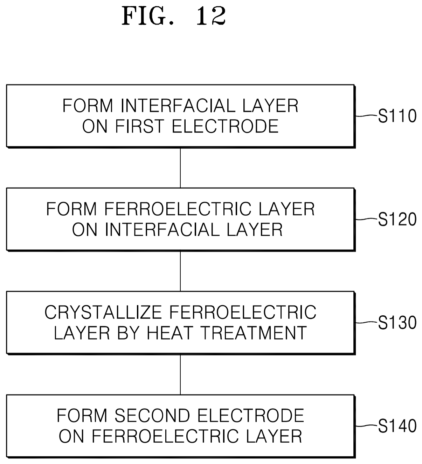

FIG. 12 is a view illustrating a method of fabricating a capacitor according to an example embodiment.

Referring to FIG. 12, an interfacial layer is formed on a first electrode (S110). Then, a ferroelectric layer is formed on the interfacial layer (S120). The ferroelectric layer may have an amorphous structure before being heat treated. The ferroelectric layer may be crystallized through heat treatment (S130). The ferroelectric layer may include an orthorhombic phase or a rhombohedral phase. Then, a second electrode is formed on the ferroelectric layer (S140). The first electrode, the interfacial layer, the ferroelectric layer, and the second electrode may each be formed by a physical vapor deposition method, a chemical vapor deposition method, or an atomic layer deposition method.

The capacitor manufacturing method of the example embodiment allows the ferroelectric layer to be crystallized using the interfacial layer. The capacitor may reduce leakage current and/or increase capacitance by using ferroelectric properties.

The capacitor of the example embodiment may be applied to various semiconductor devices owing to the ferroelectric properties of the capacitor.

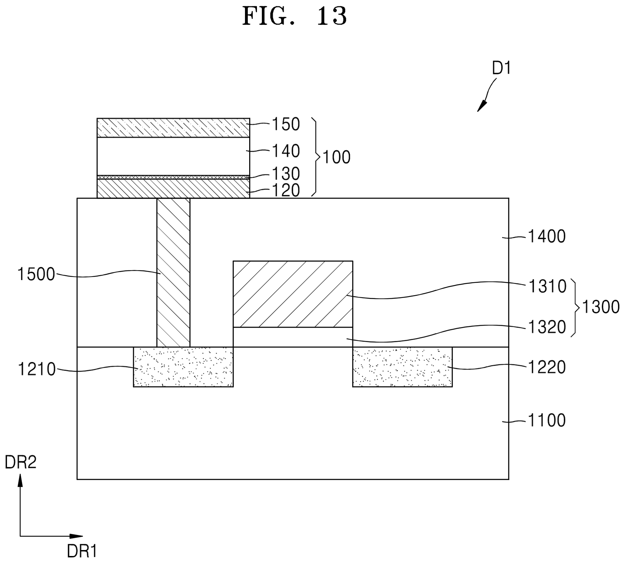

FIG. 13 is a cross-sectional view illustrating a semiconductor device D1 according to an example embodiment. For conciseness of illustration, elements substantially identical to those described with reference to FIG. 1 may not be described here.

Referring to FIG. 13, the semiconductor device D1 may include a substrate 1100, a gate structure 1300, an interlayer insulating layer 1400, a contact 1500, and a capacitor 100. The substrate 1100 may include a semiconductor substrate. For example, the substrate 1100 may include a silicon substrate, a germanium substrate, or a silicon-germanium substrate.

A first source/drain region 1210 and a second source/drain region 1220 may be provided in upper portions of the substrate 1100. The first and second source/drain regions 1210 and 1220 may be apart from each other in a first direction DR1 parallel to an upper surface of the substrate 1100. The first and second source/drain regions 1210 and 1220 may be formed by doping the substrate 1100 with a dopant.

The gate structure 1300 may be provided on the substrate 1100. The gate structure 1300 may be provided between the first and second source/drain regions 1210 and 1220. The gate structure 1300 may include a gate electrode 1310 and a gate insulating layer 1320. The gate electrode 1310 may include a conductive material. For example, the gate electrode 1310 may include metal or polysilicon.

The gate insulating layer 1320 may be disposed between the gate electrode 1310 and the substrate 1100. The gate insulating layer 1320 may insulate the substrate 1100 from the gate electrode 1310. The gate insulating layer 1320 may include a dielectric material. For example, the gate insulating layer 1320 may include a Si oxide (e.g., SiO₂), an Al oxide (e.g., Al₂O₃), or a high-k material (e.g., HfO₂).

The interlayer insulating layer 1400 may be provided on the substrate 1100 to cover the gate structure 1300. The interlayer insulating layer 1400 may include an insulating material. For example, the interlayer insulating layer 1400 may include an Si oxide (e.g., SiO₂), an Al oxide (e.g., Al₂O₃), or a high-k material (e.g., HfO₂).

The capacitor 100 may be provided on the interlayer insulating layer 1400. The capacitor 100 may include a first electrode 120, an interfacial layer 130, a ferroelectric layer 140, and a second electrode 150. The first electrode 120, the interfacial layer 130, the ferroelectric layer 140, and the second electrode 150 may be substantially identical to those described with reference to FIG. 1. In addition, instead of the capacitor 100, the capacitor 100A, 100B, or 100C described with reference to FIGS. 2, 3, or 4 may be applied to the semiconductor device D1 shown in FIG. 13.

The contact 1500 may be provided between the first electrode 120 and the first source/drain region 1210. The contact 1500 may penetrate the interlayer insulating layer 1400. The contact 1500 may electrically connect the first electrode 120 and the first source/drain region 1210 to each other. The contact 1500 may include a conductive material (e.g., a metal).

The ferroelectric layer 140, crystallized by the interfacial layer 130, may have enhanced ferroelectric properties. Thus, the stability and/or reliability of the semiconductor device D1 may be improved.

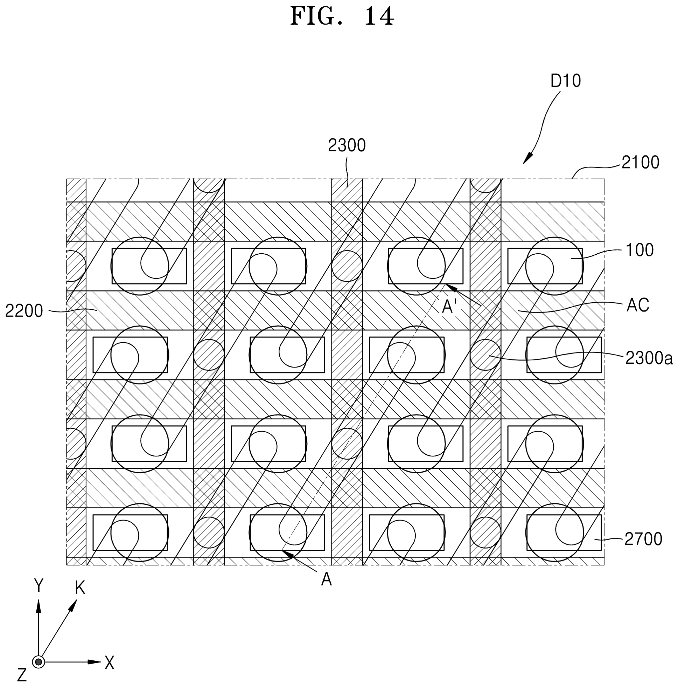

FIG. 14 illustrates a semiconductor device D10 according to another example embodiment. The semiconductor device D10 has a structure in which a plurality of capacitors 100 and a plurality of field-effect transistors are repetitively arranged.

Referring to FIG. 14, the semiconductor device D10 may include: a substrate 2100 including sources, drains, and channels, the field-effect transistors including gate stacks 2200, contact structures 2700 arranged on the substrate 2100 without overlapping the gate stacks 2200, and the capacitors 100 arranged on the contact structures 2700. The semiconductor device D10 may further include bit line structures 2300 electrically connecting the field-effect transistors to each other.

Although FIG. 14 illustrates an example in which the contact structures 2700 and the capacitors 100 of the semiconductor device D10 are repetitively arranged in X and Y directions, example embodiments are not limited thereto. For example, the contact structures 2700 may be arranged in the X and Y directions, and the capacitors 100 may be arranged in a hexagonal shape such as a honeycomb structure.

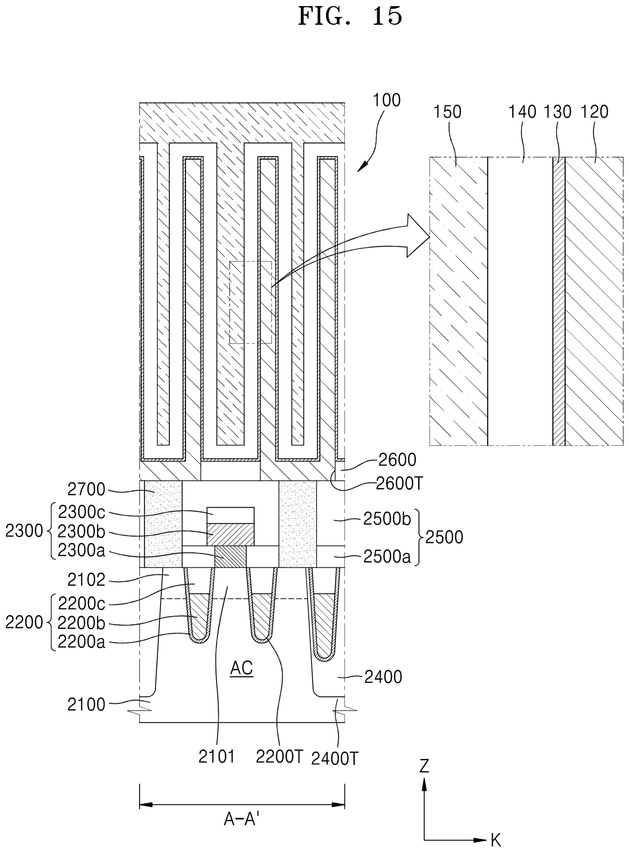

FIG. 15 is a cross-sectional view of the semiconductor device D10, taken along line A-A' of FIG. 14.

Referring to FIG. 15, the substrate 2100 may have a shallow trench isolation (STI) structure including a device isolation layer 2400. The device isolation layer 2400 may be a single-layer structure formed by one type of insulating layer or a multilayer structure formed by a combination of two or more types of insulating layers. The device isolation layer 2400 may include a device isolation trench 2400T in the substrate 2100, and the device isolation trench 2400T may be filled with an insulating material. The insulating material may include fluoride silicate glass (FSG), undoped silicate glass (USG), boro-phospho-silicate glass (BPSG), phospho-silicate glass (PSG), flowable oxide (FOX), plasma enhanced tetra-ethyl-ortho-silicate (PE-TEOS), and/or Tonen silazane (TOSZ). However, example embodiments are not limited thereto.

The substrate 2100 may further include an active region AC defined by the device isolation layer 2400, and gate line trenches 2200T disposed parallel to an upper surface of the substrate 2100 and extending in the X direction. The active region AC may have a relatively long island shape with a major axis and a minor axis. As illustrated in FIG. 14, the major axis of the active region AC may be aligned with a K direction parallel to the upper surface of the substrate 2100. The gate line trenches 2200T may intersect the active region AC at a predetermined depth from the upper surface of the substrate 2100 or may be arranged within the active region AC. A gate line trench 2200T may be disposed inside the device isolation trench 2400T. For example, a bottom surface of the gate line trench 2200T disposed inside the device isolation trench 2400T may be lower than bottom surfaces of the gate line trenches 2200T disposed inside the active region AC.

A first source/drain 2101 and a second source/drain 2102 may be arranged in an upper portion of the active region AC at both sides of a gate line trench 2200T.

Gate stacks 2200 may be disposed in the gate line trenches 2200T. For example, a gate insulating layer 2200a, a gate electrode 2200b, and a gate capping layer 2200c may be sequentially disposed in each of the gate line trenches 2200T. The gate insulating layer 2200a and the gate electrode 2200b may be understood by referencing the description given above. The gate capping layer 2200c may include silicon oxide, silicon oxynitride, and/or silicon nitride. The gate capping layer 2200c may be disposed on the gate electrode 2200b to fill a remaining portion of the gate line trench 2200T.

A bit line structure 2300 may be disposed on the first source/drain 2101. The bit line structure 2300 may be provided parallel to the upper surface of the substrate 2100 and may extend in the Y direction. The bit line structure 2300 may include a bit line contact 2300a, a bit line 2300b, and a bit line capping layer 2300c that are sequentially stacked on the upper surface of the substrate 2100. For example, the bit line contact 2300a may include polysilicon, the bit line 2300b may include a metal material, and the bit line capping layer 2300c may include an insulating material such as silicon nitride or silicon oxynitride. FIG. 15 illustrates an example in which the bit line contact 2300a has a bottom surface at the same level as the upper surface of the substrate 2100. However, the bit line contact 2300a may extend into a recess (not shown) formed in the substrate 2100 to a certain depth from the upper surface of the substrate 2100, and thus, the bottom surface of the bit line contact 2300a may be lower than the upper surface of the substrate 2100.

The bit line structure 2300 may further include an intermediate layer (not shown) between the bit line contact 2300a and the bit line 2300b. The intermediate layer may include metal silicide such as tungsten silicide, and/or a metal nitride such as tungsten nitride. Additionally, a bit line spacer (not shown) may be formed on a side wall of the bit line structure 2300. The bit line spacer may have a single-layer or multilayer structure and may include an insulating material such as silicon oxide, silicon oxynitride, or silicon nitride. The bit line spacer may further include an air gap (not shown).

A contact structure 2700 may be disposed on the second source/drain 2102. The contact structure 2700 and the bit line structure 2300 may be disposed on different source/drains of the substrate 2100. The contact structure 2700 may be provided by sequentially stacking a lower contact pattern (not shown), a metal silicide layer (not shown), and an upper contact pattern (not shown) on the second source/drain 2102. In addition, the contact structure 2700 may further include a barrier layer (not shown) surrounding lateral and bottom surfaces of the upper contact pattern. For example, the lower contact pattern may include polysilicon, the upper contact pattern may include a metal material, and the barrier layer may include a conductive metal nitride.

A capacitor 100 may be disposed on the substrate 2100 and electrically connected to the contact structure 2700. The capacitor 100 may be substantially the same as the capacitor 100 described with reference to FIG. 1. In addition, the capacitor 100A, 100B, or 100C described with reference to FIGS. 2, 3, or 4 may be used instead of the capacitor 100.

The capacitor 100 may include a first electrode 120 electrically connected to the contact structure 2700, a second electrode 150 provided apart from the first electrode 120, and an interfacial layer 130 and a ferroelectric layer 140 that are arranged between the first electrode 120 and the second electrode 150.

An interlayer insulating layer 2500 may be further disposed between the capacitor 100 and the substrate 2100. The interlayer insulating layer 2500 may be provided in a space between the capacitor 100 and the substrate 2100 in which no other structures are arranged. For example, the interlayer insulating layer 2500 may cover wiring and/or electrode structures, such as the bit line structure 2300, the contact structure 2700, and the gate stack 2200, which are provided on the substrate 2100. For example, the interlayer insulating layer 2500 may surround walls of the contact structure 2700. The interlayer insulating layer 2500 may include a first interlayer insulating layer 2500a surrounding the bit line contact 2300a, and a second interlayer insulating layer 2500b covering lateral surfaces and/or upper surfaces of the bit line 2300b and the bit line capping layer 2300c.

The first electrode 120 of the capacitor 100 may be disposed on the interlayer insulating layer 2500, for example, on the second interlayer insulating layer 2500b of the interlayer insulating layer 2500. When a plurality of capacitors 100 are arranged, bottom surfaces of the first electrodes 120 may be separated from each other by an etch stop layer 2600. In other words, the etch stop layer 2600 may include openings 2600T, and the bottom surfaces of the first electrodes 120 of the capacitors 100 may be arranged within the openings 2600T.

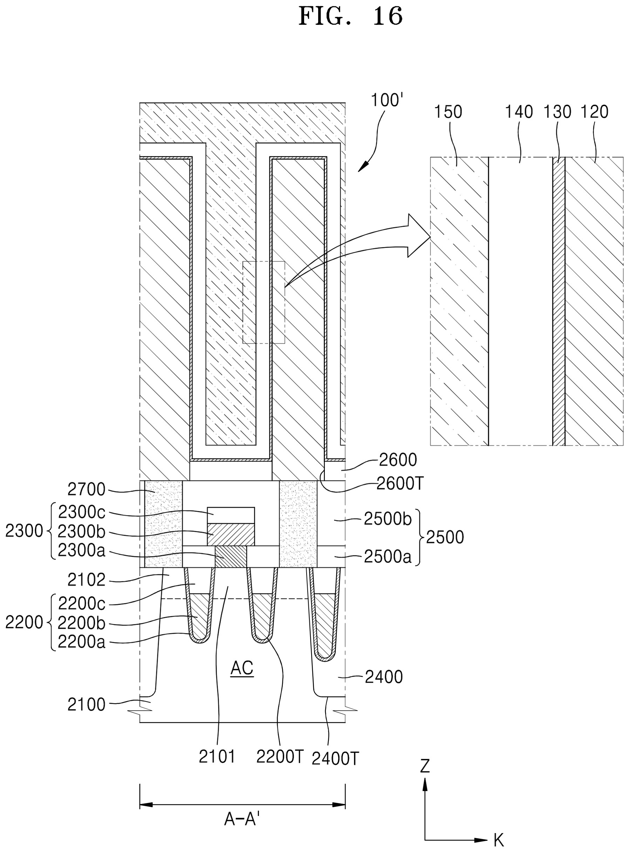

The first electrode 120 may have a closed-bottom cylindrical shape or a cup shape, as illustrated in FIG. 15. In another example embodiment shown in FIG. 16, a first electrode 120 of a capacitor 100' may have a pillar shape, such as a cylinder, tetragonal prism, or polygonal prism shape, extending in a vertical direction (Z direction). The capacitor 100' may further include a support portion (not shown) to reduce or prevent tilting or collapsing of the first electrode 120, and the support portion may be provided on a side wall of the first electrode 120.

The semiconductor device D10 may be manufactured by referring to general methods known in the art. For example, the semiconductor device D10 may be manufactured by a method including the following operations i) to xvi):
i) forming a device isolation trench 2400T in a substrate 2100 and forming a device isolation layer 2400 in the device isolation trench 2400T (defining an active region AC in the substrate 2100 by the device isolation layer 2400 and/or the device isolation trench 2400T),
ii) filling the device isolation trench 2400T with an insulating material,
iii) forming a first source/drain 2101 and a second source/drain 2102 in an upper region of the active region AC by implanting dopant ions into the substrate 2100,
iv) forming a gate line trench 2200T in the substrate 2100,
v) forming a gate insulating layer 2200a, a gate electrode 2200b, and a gate capping layer 2200c inside the gate line trench 2200T,
vi) forming a first interlayer insulating layer 2500a on the substrate 2100 and forming an opening (not shown) to expose an upper surface of the first source/drain 2101,
vii) forming, in the opening formed in operation vi), a bit line structure 2300 electrically connected to the first source/drain 2101,
viii) forming a second interlayer insulating layer 2500b to cover upper and lateral surfaces of the bit line structure 2300,
ix) forming an opening (not shown) in the first and second interlayer insulating layers 2500a and 2500b to expose an upper surface of the second source/drain 2102.
x) forming, in the opening formed in operation ix), a contact structure 2700 electrically connected to the second source/drain 2102,
xi) forming an etch stop layer 2600 and a mold layer (not shown) on the second interlayer insulating layer 2500b and the contact structure 2700,
xii) forming an opening (not shown) in the etch stop layer 2600 and the mold layer (not shown) to expose an upper surface of the contact structure 2700.
xiii) forming a first electrode 120 to cover internal walls (bottom and lateral surfaces) of the opening formed in operation xii,
xiv) removing the mold layer (not shown),
xv) forming an interfacial layer 130 and a ferroelectric layer 140 on the first electrode 120, and
xvi) forming a second electrode 150 on the ferroelectric layer 140.

The types and/or order of the operations mentioned above are not limited and may be modified, and some operations may be omitted or added. In addition, processes such as deposition, patterning, and etching processes known in the art may be used to form elements in each of the operations. For example, an etch-back process may be used when an electrode is formed. In operation v), the gate electrode 2200b may be formed by forming a conductive layer on the gate insulating layer 2200a and then removing an upper portion of the conductive layer by a desired (or alternatively, predetermined) height through an etch-back process. Furthermore, in operation xiii), the first electrode 120 may be formed to cover an upper surface of the mold layer and the bottom and lateral surfaces of the opening, and then, portions of the first electrode 120 that are on the upper surface of the mold layer may be removed through an etch-back process to fabricate a structure including a plurality of first electrodes 120. In another example, a planarization process may be employed. For instance, in operation v), the gate capping layer 2200c may be formed by filling a remaining portion of the gate line trench 2200T with an insulating material and then planarizing the insulating layer until an upper surface of the substrate 2100 is exposed.

According to another aspect, the capacitors 100, 100A, 100B, and 100C, and the semiconductor devices D1 and D10 described above may be applied to various electronic devices. For example, the capacitors 100, 100A, 100B, and 100C and/or the semiconductor devices D1 and D10 may be used as logic devices or memory devices in various electronic devices. For example, the capacitors 100, 100A, 100B, and 100C, and the semiconductor devices D1 and D10 may be used for arithmetic operations, program execution, and/or temporary data storage in electronic devices such as mobile devices, computers, laptops, sensors, network devices, or neuromorphic devices. The capacitors 100, 100A, 100B, and 100C and the semiconductor devices D1 and D10 of the example embodiments may be particularly useful in electronic devices having relatively high data transfer rates and performing continuous data transmission.

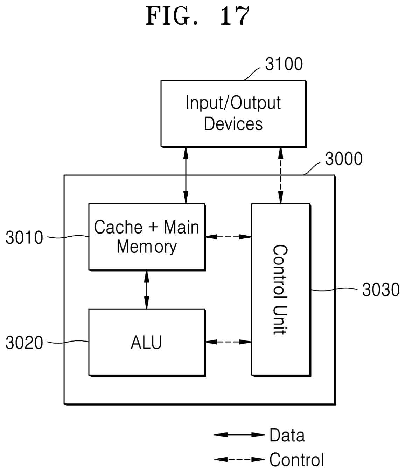

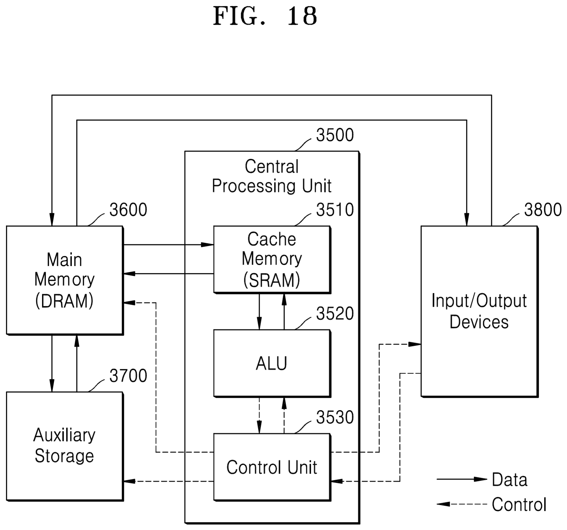

FIGS. 17 and 18 are conceptual views schematically illustrating device architectures applicable to electronic devices according to some example embodiments.

Referring to FIG. 17, a device architecture 3000 may include a memory unit 3010, an arithmetic logic unit (ALU) 3020, and a control unit 3030. The memory unit 3010, the ALU 3020, and the control unit 3030 may be electrically connected to each other. For example, the device architecture 3000 may be implemented as a single chip including the memory unit 3010, the ALU 3020, and the control unit 3030. For example, the memory unit 3010, the ALU 3020, and the control unit 3030 may be connected to each other on a chip through metal lines for direct communication therebetween. The memory unit 3010, the ALU 3020, and the control unit 3030 may be monolithically integrated on a single substrate to form a single chip. Input/output devices 3100 may be connected to the device architecture 3000. In addition, the memory unit 3010 may include main memory and cache memory. The device architecture 3000 may be an on-chip memory processing unit. The memory unit 3010, the ALU 3020, and/or the control unit 3030 may each independently include one of the capacitors 100, 100A, 100B, or 100C described above.

Referring to FIG. 18, a cache memory 3510, an ALU 3520, and a control unit (or a controller or control circuitry) 3530 may form a central processing unit (CPU) 3500. The cache memory 3510 may include static random-access memory (SRAM). Main memory 3600 and auxiliary storage 3700 may be provided separately from the CPU 3500. The main memory 3600 may be dynamic random-access memory (DRAM) and may include one of the capacitors 100, 100A, 100B, and 100C described above. In some cases, the device architectures may be implemented in the form in which unit computing unit devices and unit memory devices are adjacent to each other on a single chip without any distinction sub-units. Input/output devices 3800 may be connected to the main memory 3600.

Any functional blocks shown in the figures and described above may be implemented in processing circuitry such as hardware including logic circuits, a hardware/software combination such as a processor executing software, or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

As described above, according to one or more of the example embodiments described above, the capacitor may include a ferroelectric layer having relatively high ferroelectricity even with a relatively small thickness. The ferroelectric layer of the capacitor may exhibit relatively high remnant polarization.

According to one or more of the example embodiments described above, the capacitor includes an interfacial layer having a negative charge between an electrode and a ferroelectric layer. Therefore, positively charged oxygen vacancies present in the ferroelectric layer may be stably controlled to form an orthorhombic or rhombohedral phase having relatively high crystallinity in the ferroelectric layer, and thus, the ferroelectric layer may have relatively high ferroelectricity.

According to one or more of the example embodiments described above, the capacitor fabricating method may use an interfacial layer to form a ferroelectric layer having relatively stable ferroelectricity.

It should be understood that the example embodiments described herein should be considered in a descriptive sense only and not for purposes of limitation. Descriptions of features or aspects within each example embodiment should typically be considered as available for other similar features or aspects in other example embodiments. While one or more example embodiments have been described with reference to the figures, it will be understood by those of ordinary skill in the art that various changes in form and details may be made therein without departing from the scope as defined by the following claims.

## Claims

1. A capacitor comprising:
a first electrode;
a ferroelectric layer on the first electrode;
a second electrode on the ferroelectric layer; and
an interfacial layer between the first electrode and the ferroelectric layer and/or between the ferroelectric layer and the second electrode,
wherein the interfacial layer comprises a perovskite structure material,
the perovskite structure material comprises an oxide of metals, the metals comprising a divalent cation, a tetravalent cation, and a trivalent cation, and
the trivalent cation comprises at least one selected from Sc, Y, La, Ce, Pr, Nd, Sm, Dy, Al, Ga, or In.

2. The capacitor of claim 1, wherein the divalent cation of the interfacial layer comprises at least one selected from La, Sr, Ba, Nd, Pb, Ca, Na, Eu, or Rb.

3. The capacitor of claim 1 or 2, wherein the tetravalent cation of the interfacial layer comprises at least one selected from Ti, Ta, Zr, Hf, or Sn.

4. The capacitor of any preceding claim, wherein the first electrode and the second electrode comprise at least one selected from a perovskite structure material or a rock-salt structure material.

5. The capacitor of claim 4, wherein the first electrode and the second electrode comprise at least one selected from SrRuO₃, SrIrO₃, SrFeO₃, SrCoO₃, SrMnO₃, CaRuO₃, LaMnO₃, La₍ₓ₎Sr₍₁₋ₓ₎MnO₃, LaNiO₃, LaFeO₃, LaCoO₃, BN, AIN, GaN, Si₃N₄, Ta₃N₅, Cu₃N, InN, Zr₃N₄, Hf₃N₄, LaN, LuN, TiN, MN, VN, TaN, WN, HfN, NbN, and ZrN.

6. The capacitor of any preceding claim, wherein the ferroelectric layer comprises at least one selected from a perovskite structure, a fluorite structure, or a wurtzite structure.

7. The capacitor of claim 6, wherein the ferroelectric layer comprises at least one selected from BaTiO₃, Ba₍ₓ₎Sr₍₁₋ₓ₎TiO₃, PbTiO₃, PbZrO₃, PbTi₍ₓ₎Zr₍₁₋ₓ₎O₃, PbMg₍ₓ₎Nb₍₁₋ₓ₎O₃, PbZn₍ₓ₎Nb₍₁₋ₓ₎O₃, PbFe₍ₓ₎Nb₍₁₋ₓ₎O₃, PbNi₍ₓ₎Nb₍₁₋ₓ₎O₃, PbMg₍ₓ₎Ta₍₁₋ₓ₎O₃, PbMg₍ₓ₎W₍₁₋ₓ₎O₃, BiFeO₃, KNbO₃, NaNbO₃, or Sr₂Bi₂TaO₉.

8. The capacitor of claim 6 or 7, wherein the ferroelectric layer comprises HfO₂ or HfO₂ doped with A, and A comprises at least one selected from Sr, Sc, Y, Al, La, Si, Gd, Zr, N, or Ge.

9. The capacitor of claim 8, wherein the ferroelectric layer comprises hafnium zirconium oxide (HZO).

10. The capacitor of claim 6, wherein the ferroelectric layer comprises at least one selected from Sc₍ₓ₎Al₍₁₋ₓ₎N, Y₍ₓ₎Al₍₁₋ₓ₎N, Mg₍ₓ₎Zr₍₁₋ₓ₎N, Ga₍ₓ₎Sc₍₁₋ₓ₎N, Sc₍ₓ₎Al_{(1-x-y)}Ga_{(y)}N, or Zn₍ₓ₎Mg₍₁₋ₓ₎O.

11. The capacitor of any preceding claim, wherein the interfacial layer has a negative charge.

12. A semiconductor device comprising:
a substrate;
a gate structure on the substrate;
a source region and a drain region being apart from each other in the substrate; and
a capacitor according to any preceding claim over the substrate.

13. The semiconductor device of claim 12, wherein the ferroelectric layer has a superlattice structure.

14. The semiconductor device of claim 12 or 13, wherein the interfacial layer has a negative charge.

15. A method of fabricating a capacitor, the method comprising:
forming a ferroelectric layer on a first electrode;
forming a second electrode on the ferroelectric layer; and
forming an interfacial layer between the first electrode and the ferroelectric layer and/or between the ferroelectric layer and the second electrode,
wherein the interfacial layer has a perovskite structure material,
the interfacial layer comprises an oxide of metals, the metals comprise a divalent cation, a tetravalent cation, and a trivalent cation, and
the trivalent cation comprises at least one selected from Sc, Y, La, Ce, Pr, Nd, Sm, Dy, Al, Ga, or In.
